Europäisches Patentamt

(19) European Patent Office

Office européen des brevets

(11) Publication number: **0 016 636**
**B1**

(12) **EUROPEAN PATENT SPECIFICATION**

(45) Date of publication of patent specification: **08.02.84**

(51) Int. Cl.³: **H 01 L 27/10, G 11 C 17/04**

(21) Application number: **80300837.4**

(22) Date of filing: **19.03.80**

(54) CCD read-only memory.

(30) Priority: **26.03.79 US 23860**

(43) Date of publication of application:
**01.10.80 Bulletin 80/20**

(45) Publication of the grant of the patent:
**08.02.84 Bulletin 84/6**

(84) Designated Contracting States:
**DE FR GB NL**

(56) References cited:
**US - A - 3 654 499**
**US - A - 4 072 977**

**IEEE TRANSACTIONS ON ELECTRON DEVICES,
vol. ED-25, January 1978 pages 33-41 New
York, U.S.A. A.F. TASCH et al.: "The Hi-C RAM
Cell concept"**

(73) Proprietor: **Hughes Aircraft Company
Centinela Avenue and Teale Street
Culver City, California 90009 (US)**

(72) Inventor: **Nash, Greg
2027 Linda Flora Drive
Los Angeles California (US)**

(74) Representative: **Milhench, Howard Leslie et al,
A.A. Thornton & Co. Northumberland House
303/306 High Holborn
London, WC1V 7LE (GB)**

CCD Read-only memory

The invention relates to a CCD (charge-coupled device) read-only memory (ROM) comprising a semiconductor substrate of a predetermined conductivity type and a plurality of charge transfer electrodes selectively spaced above, and insulated from, a major surface of the substrate and arranged to define a series of memory cells in the substrate A ROM of this general structure is known from U.S. Patent Specification 4,072,977.

There are two basic classes of solid state read-only memories (hereinafter referred to as ROMs)— namely, random access memories and serial access memories. Random access MOS ROMs are generally well known. They typically consist of a matrix of Metal-Oxide-Silicon-Field-Effect Transistors (MOSFETs) that have been constructed with an alterable threshold voltage which is used to electrically indicate the storage of a binary "1" or "0". The second class of ROMs, i.e., serial access memories are not known to be presently commercially available as MOS devices.

A typical solid-state random access ROM is a MNOS (Metal Nitride Oxide Semiconductor) memory device such as described by Dov Frohmar and Bentchowsky in *Proceedings IEEE*, Vol. 58, August 1970 pages 1207—1219. The MNOS structure described in this publication is configured in the form of a field-effect transistor fabricated on a semiconductor substrate having an insulated gate electrode and source and drain terminals that "current access" the stored charge in the transistor. A composite insulating layer disposed between the gate electrode and the semiconductor substrate of the transistor consists of a thin layer of silicon oxide on which a layer of silicon nitride has been applied. By applying a voltage pulse on the gate electrode, charge carriers are transported from the semiconductor substrate to the thin silicon oxide layer by means of a phenomena known as tunnelling. The number of charge carriers trapped at the interface of the silicon oxide layer and the silicon nitride layer determines the threshold voltage of the transistor, which voltage in turn controls the magnitude of the current flow between the source and drain terminals for a specified read voltage on the gate electrode. However, the problem encountered with this prior MNOS structure is that it requires at least one transistor per bit of binary information, so that the packing density is very small and limited.

Another method of determining the threshold voltage of a field-effect transistor gate in the above type of MNOS structure is by injection of charge created during an avalanche breakdown in the semiconductor substrate of the transistor. A semiconductor memory device using this principle is known in the art as a FAMOS (Floating-Gate Avalanche Metal Oxide Semiconductor) structure, and one such structure of this type is described by Dov Frohman and Bentchowsky in *IEEE Journal of Solid-State Circuits*, Vol. SC6, October, 1971, pages 301—306. The device described in the latter publication is a field-effect transistor with a source, a drain, and an insulated floating gate electrode in the form of a nonconnected conductive layer which is usually surrounded by insulating material and disposed above the surface of the semi-conductor substrate. By applying a reverse bias of sufficient magnitude across the source substrate PN junction or the drain-substrate PN junction to produce avalanche breakdown, charge carriers are generated at the junction. On account of the electrical field applied across the PN junction at reverse breakdown the energy of these charge carriers reaches a high level such that these carriers are capable of travelling from their energy band in the semiconductive substrate to a corresponding energy band in the insulative layer below the gate electrode. Such charges travelling in the insulating layer near the floating gate electrode will therefore charge this electrode. Thus, during operation of this FAMOS type device, electrons can move from the conduction band in the semiconductor substrate to the conduction band in the insulating layer. Conversely, holes of the valance band in the semiconductor substrate may shift to the valance bande in the insulating layer. However, once again the important drawback of this latter avalance injection structure is the inefficient packing density which results from the requirement of one transistor per bit to be stored in the structure.

An alternate method of cell operation frequently used in connection with a MNOS memory device of the above type is charge addressing the MNOS structure. This operation is accomplished by controlling the silicon oxide electric field strength and current density of the device which is dependent upon the magnitude of signal charge beneath a deep depleted MNOS capacitor formed by the device. In operation, the surface potential of this capacitor is collapsed and the silicon oxide electric field strength increases with an increase in silicon oxide tunnelling current. The transfer of signal charge from the device is typically accomplished using an output charge-coupled device (CCD). The combination of charge transfer and MNOS principles for signal control, address, and nonvolatile storage for this latter type of device has been set forth by K. Goser and K. Knaver in *IEEE Journal of Solid-State Circuits*, SC-9, pages 148—150, June 1974 and by Y. T. Chan et al in *Applied Physics Letters*, Vol. 22, pages 650—652, 15 June 1973. The charge storage sites of these MNOS structures are located inside a stepped dielectric 2 phase or 3 phase CCD shift register.

This latter MNOS device also has a poor packing density and an inadequate charge handling capability, both of which result in poor write characteristics and ineffective write/inhibit operation for the device. Additionally, high voltage clocks required for good transfer efficiency in these devices cause spurious write operation and poor read operation due to the large access time to the first stored bit, and these characteristics tend to degrade memory retention caused by small write and read disturb effects.

A ROM CCD device that has a higher packing density than all of the above-identified prior art structures is a nonvolatile charge-addressed memory (NOVCAM) cell with parallel write and read-out injection for block-oriented random-access memory (BORAM) applications as set forth, for example, by White et al in the *IEEE Journal of Solid-State Circuits,* Vol. SC19, No. 5, October 1975. The NOVCAM cell described in this publication comprises a combined CCD shift register and a thin-oxide MNOS memory structure to provide a higher packing density. However, the charge transfer efficiency of this latter device is severely degraded by the thin oxide at the MNOS surface, and therefore this circuit is not well suited for ROM CCD operation with high charge transfer efficiency.

The general purpose of this invention is to provide a new and improved CCD ROM structure that has a higher packing density than the MNOS and FAMOS static ROM and the charge addressed CCD described above, and further has improved operating characteristics (e.g., higher transfer efficiency) relative to the NOVCAM cell described above.

This general purpose is accomplished by a non-volatile CCD read-only memory (ROM) comprising a semiconductor substrate (12) of a predetermined conductivity type and a plurality of charge transfer electrodes selectively spaced above, and insulated from, a major surface of the substrate and arranged to define a series of memory cells in the substrate, characterized in that each memory cell of said series is arranged beneath a corresponding one of said charge transfer electrodes and that selected ones of the memory cells include a double conductivity type region consisting of a first region adjacent said major surface and of a first conductivity type which is different from said predetermined conductivity type of the substrate and a second region adjacent said first region and of a second conductivity type which is the same as the conductivity type of the substrate (12) but has a higher impurity concentration, whereby the resulting neutralizing effect enables the substrate to receive a fixed charge as necessary for ROM operation without significantly changing the surface potential of the substrate and thus the clocked CCD operation.

In operation of such a CCD ROM structure, the electrodes are responsive to clocking signals so as to produce and define, when energized, a series of selectively spaced regions of fixed charge in the semiconductor substrate and the first-mentioned diffusion or implantation region provides a fixed charge representative of binary information required for read only memory operation. The second region produced by the second diffusion or implantation provides a neutralizing effect on the first diffusion or implantation region such that the first region does not significantly and adversely affect the surface potential of the CCD under the last electrode of any given memory cell.

The first diffused or ion-implanted region thus provides a fixed charge representative of certain ROM information and the second diffused or ion-implanted region provides a neutralizing effect on the surface potential of the CCD above the first and second regions, defined above, and thus tends to offset the effect that the charge of the first diffused or implanted region has on this surface potential.

The ROM structure of the present invention may be utilized in a system having an input circuit which supplies charge representative of an input signal to the input cell, and also having an output circuit which converts the charge from the output cell into an appropriate output signal. The system further includes a refreshing means for feeding back the output signal to the input circuit thereof. The invention can provide a non-volatile CCD memory structure of the type described which is capable of a high charge storage density while maintaining a relatively high charge transfer efficiency, and which can perform as a non-memory, linear CCD when it is not connected with feedback as a read only memory.

In order that the invention might be clearly understood several embodiments thereof will now be described with reference to the accompanying drawings wherein:—

Figure 1a is a partial plan view of a non-volatile CCD ROM fabricated in accordance with the present invention;

Figure 1b is a schematic diagram of clocking circuitry which may be used in combination with the device of Figure 1a;

Figure 2 is an enlarged cross section view of one CCD ROM cell used in Figures 1a and 1b;

Figure 3a is a cross-sectional view of a CCD with one implant of a conductivity-type opposite to that of the substrate;

Figure 3b is a plot of the surface potential beneath the electrode over the implant of two positions in Figure 3a for an applied voltage;

Figure 3c is a plot of the surface potential beneath the electrode of the CCD of Figure 3b to which a larger voltage than in Figure 3b has been applied;

Figure 4a is an equivalent circuit of the CCD of Figure 3a;

Figure 4b is a plot of the potential beneath the electrode as a function of distance into the substrate, with the presence of two implants;

Figure 5a is a plot of the doping concentration of the CCD ROM cell in Figure 2 versus distance into the semiconductor substrate in which the cell is formed;

Figure 5b is a plot of the electric field profile for the CCD ROM cell in Figure 2;

Figure 5c is a plot of the surface potential beneath the clocking electrode for the CCD ROM cell of Figure 2 versus distance into the semiconductor substrate;

Figure 6 is a plan view of a charge transfer system incorporating a plurality of non-volatile CCD ROMS constructed in accordance with Figures 1b and 2 above; and

Figure 7 is a clocking diagram illustrating the voltages applied to the electrodes of Figures 1b, 2, 3a and 6.

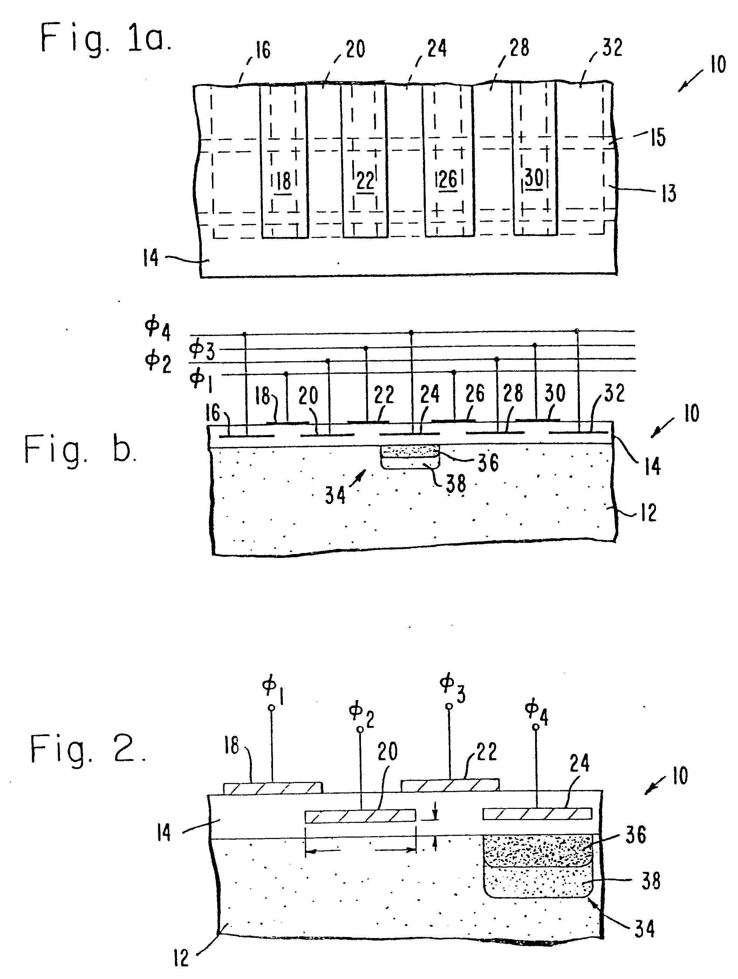

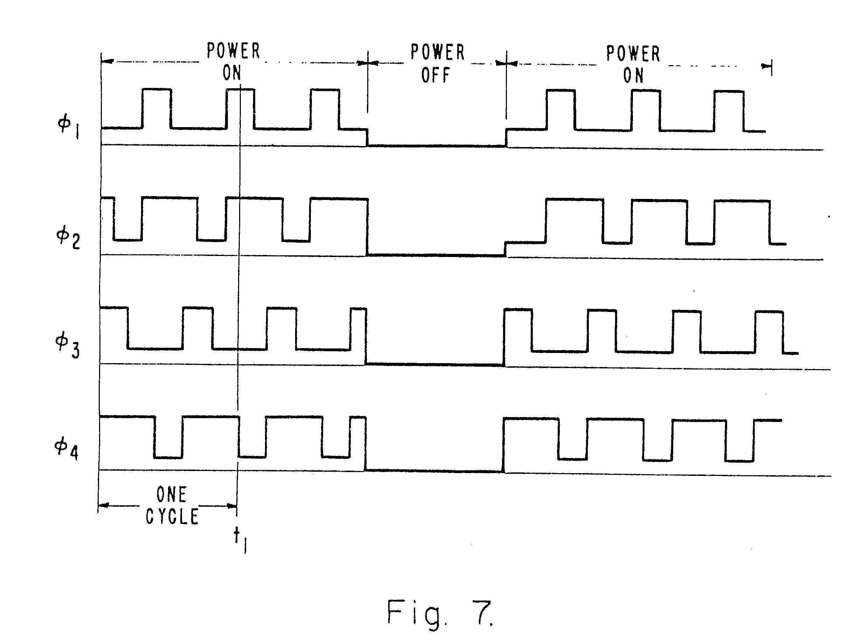

Referring first to Figures 1a, 1b and 2, a CCD shift register is formed in a semiconductor substrate 12 having a thin layer of oxide 14 deposited on its top surface. Buried in the oxide layer 14 and distributed along its surface are a plurality of individual clocking or addressing electrodes 18, 22, 26 and 30 to which potentials are applied to move charges from left to right, from one potential well (not shown) in the substrate 12 to the next. The charges are introduced (injected) into the CCD 10 by suitable input circuitry (not shown), and these injected charges are confined within a channel 13 formed in the substrate 12 and bounded by a pair of P+ channel stops 15. A $\phi_1$ clocking signal from a suitable clock source is applied to electrodes 18 and 26, a $\phi_2$ clocking signal is applied from a second appropriate clock source to electrodes 20 and 28, a $\phi_3$ clocking signal is applied to electrodes 22 and 30, and a $\phi_4$ clocking signal is applied to electrodes 16, 24 and 32. The exact phase relationships of clocking signals $\phi_1$—$\phi_4$ are shown in Figure 7 which is described in more detail below. While the CCD device of the above-described embodiment has been structured so as to respond to four separate clocking signals it may be suitably modified to respond to any number of clocking signals.

Referring more specifically to Figures 1b and 2, the CCD 10 further includes a double implanted or double diffused region 34 directly beneath the last clocked electrode 24 (in a clock cycle) for one ROM cell in the substrate 12. The doping (impurity concentration) of the first implanted or diffused region 36 of the fixed charge region 34 is chosen such that it is opposite in polarity (conductivity-type) to both the polarity of the substrate 12 and the polarity or conductivity-type of a second implanted or diffused region 38. More specifically, if a P type material is chosen for the substrate 12, then the first region 36 will have an N type conductivity and the second region 38 will have a P type conductivity. The first N planar region 36 stores binary information in the form of a fixed charge which has been introduced by impurity diffusion or ion-implantation into the substrate 12 using conventional MOS planar processing procedures including well-known lithographic masking and etching techniques which form no part of this invention. Of course, the conductivity types can be reversed with the substrate 12 having an N type conductivity and implants or diffusions 36 and 38 being P+ type and N− type respectively.

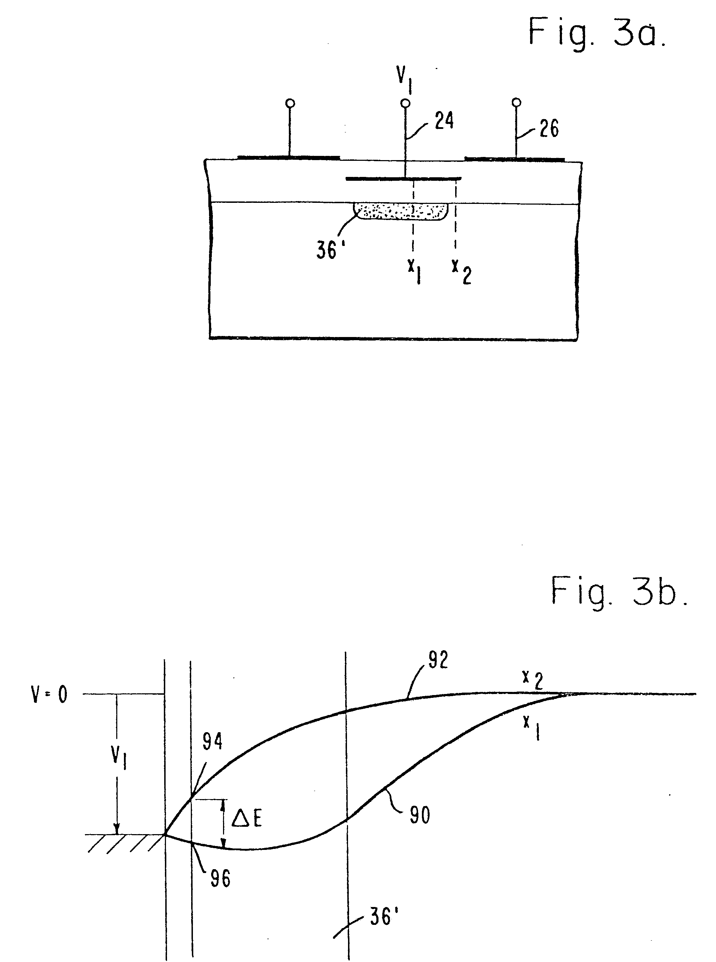

The first or upper doped region 36 has a certain amount of electron charge Q, corresponding to the stored binary information in the CCD. For proper CCD operation, this charge must be serially clocked from gate to gate along the length of the CCD structure and beneath the clocking electrodes thereof. However, the first implant or diffusion 36 alters the electrical potential profile underneath gate electrode 24 (in a manner to be described), such that if only a single diffusion or implant 36' were used, as indicated in Figure 3a, there will be an intolerable impedance to charge transport laterally across the CCD structure. Thus, if a voltage $V_1$ is applied to the gate electrode 24 in Figure 3a, the surface potential along the dimension $X_1$ under the gate electrode 24 and through the region 36' into the substrate is illustrated by curve 90 in Figure 3b. The adjacent potential beneath the outer edge of gate electrode 24 along the dimension $X_2$ and exterior to region 36' is illustrated by curve 92 in Figure 3b. In order to clock the charge Q laterally across the CCD structure in the standard CCD mode of operation, the point 94 at which the potential curve 92 intersects the $SiO_2$ interface should be equal to the point 96 at which curve 90 intersects the $SiO_2$ interface. However, using only a single implant 36' there will be an energy barrier of height $\Delta E$ preventing the flow of charge from the implant region 36' to a substrate region beneath an adjacent gate 26.

This energy barrier $\Delta E$ occurs because the implant 36' causes the CCD structure to act like a buried channel CCD (BCCD), whereas the remaining portions of the CCD structure function as a surface channel CCD (SCCD). As is known in this art, charge-transfer from a buried channel to a surface channel is not possible using standard gating schemes. This principle is set forth in a publication entitled "Liquid-Crystal electro-Optical Modulators for Optical Processing of Two-Dimensional Data" by J. Grinberg et al, SPIE Vol. 128, *Effective Utilization of Optics in Radar Systems*, 1977, pp. 253—266.

One method for transferring charge between a buried channel CCD and a surface channel CCD is to apply a relatively large voltage $V_2$ to the electrode 24 of Figure 3a and thus substantially alter the potential profiles in the underlying semiconductor material. This principle is discussed in some detail in a publication entitled "Design Considerations for a Two-Phase, Buried-Channel, Charge-Coupled Device", *The Bell System Technical Journal* Vol. 53, No. 8, October 1974, pp. 1581—1597. Using this technique, a relatively large voltage $V_2$ which is higher than $V_1$ may be applied to the same CCD electrode 24 to thereby raise the potential 90 under the electrode 24 until the charge $Q$ reaches the surface of the semiconductor substrate 12 as illustrated by curve 98 in Figure 3c. At this time, the charge in the buried channel 36' will flow along the surface of the substrate 12. This alteration in substrate potential profiles will overcome the above-described charge transfer problems between the buried and surface channels of the CCD structure.

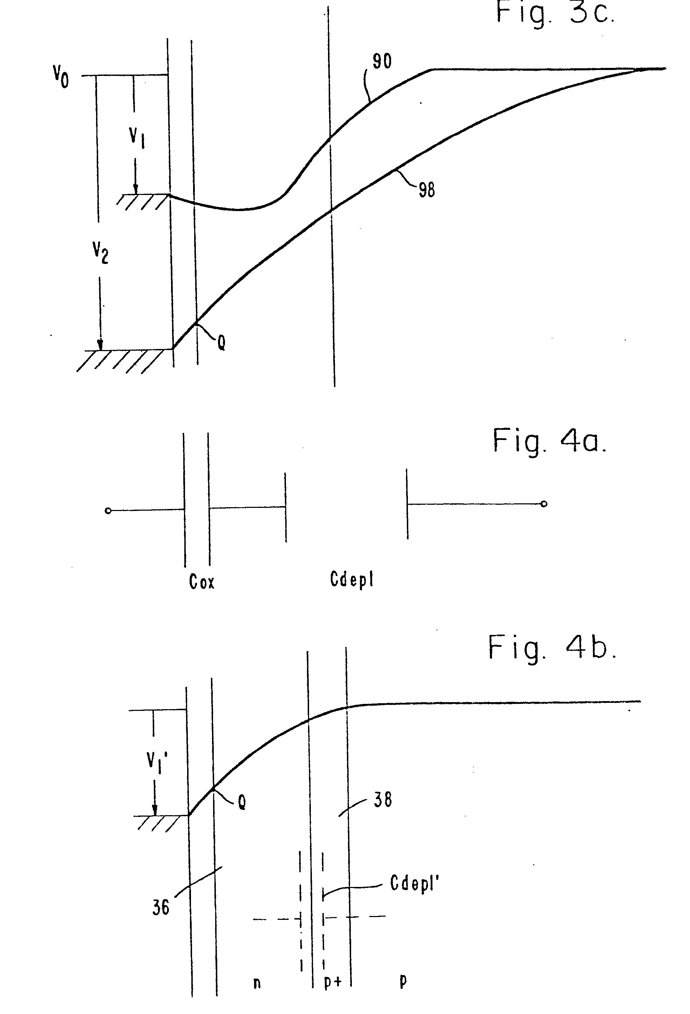

On the other hand, the voltage required to transfer charge from a single implant 36' and along the surface of the substrate 12 is quite large for all conventionally doped CCD structures and therefore renders this latter technique an impractical solution to the above charge transfer problem. To illustrate this point, the CCD structure in Figure 3a can be represented by two capacitors $C_{ox}$ and $C_{depl}$ which are connected in series as shown in Figure 4a. The capacitor $C_{ox}$ corresponds to the CCD oxide capacitance and is relatively large, since the oxide thickness is small. The second capacitor, $C_{depl}$, models the back biased PK junction at the region 36'—substrate interference and this latter capacitance is relatively small because the depletion width of this PN junction is very large. Thus, the total capacitance $C_{total}$ of the series combination $C_{ox}$ and $C_{depl}$ is also very small, and hence a large voltage (100 volts) is necessary to pull the electron charge to the surface, i.e.:

$$V = \frac{Q}{C_{total}}$$

and overcome the above described charge transfer problem.

However, in accordance with the present invention, it has been discovered that the above-described problems of buried channel to surface channel energy barriers and their respective impedances to charge transfer may be alleviated by the creation of the second, P implanted or diffused region 38 directly beneath the first N surface region 36 as shown in Figure 4b. Now, rather than having the PN junction depletion region capacitance $C_{depl}$ determined by a N P junction (where the P doping is that of the substrate), it is instead determined by a junction which, as a result of the increased P doping concentration adjacent to the N type region, has a significantly increased junction capacitance, $C_{depl}'$. This increase in $C_{depl}$ to a new value of $C_{depl}'$ as indicated in Figure 4b causes the profile of charge ($Q$) versus distance into the semiconductor substrate to assume the new contour indicated in the latter Figure. Thus, with the two doped regions 36 and 38 present in the substrate 12, a much smaller voltage $V_1'$ typically on the order of 2 volts, is sufficient to pull all of the charge $Q$ to the silicon-silicon oxide interface and enable the structure to be operated as a surface channel CCD.

Thus, there has been described a novel double diffused or double implanted CCD memory which is operable as a surface channel device, and this new and improved structure overcomes the problems described above associated with buried-to-surface channel types of charge transfer. In order to optimize charge transfer efficiency in the CCD ROM cell, the above dose and position of the second doped region 38 is adjusted to produce the same net surface potential for the composite double-implanted region 34 as would have been the case without either of the two implants 36 and 38.

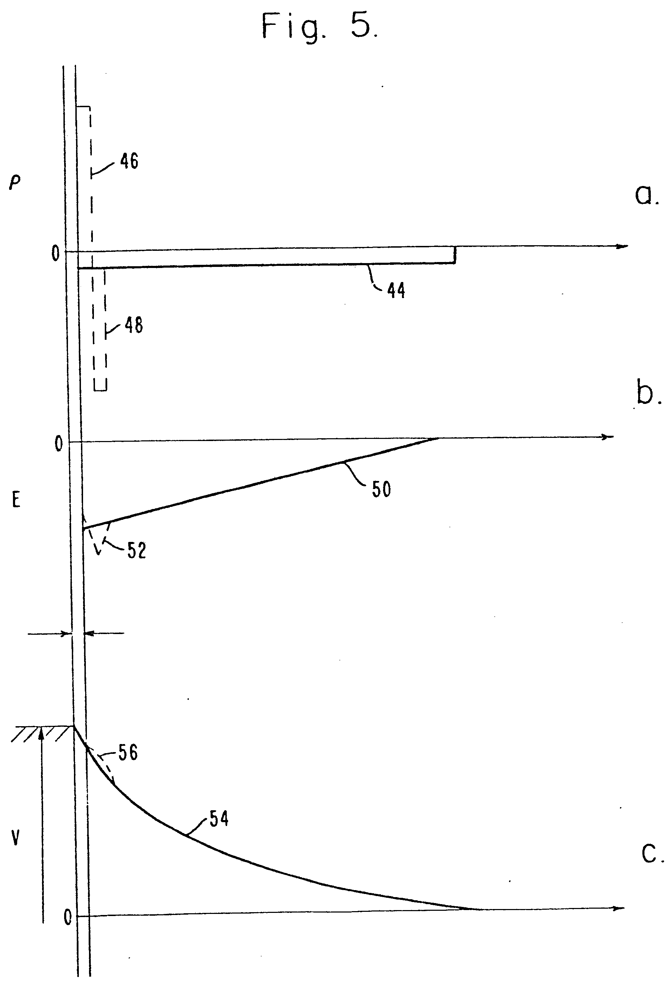

Referring now to Figure 5a, a hypothetical doping concentration $p$ of the CCD cell in Figure 2 is illustrated as a function of distance X into the substrate 12 under the electrode 24. The doping profiles for the doped regions 36 and 38 are represented by the dashed lines 46 and 48. The solid line 44 represents the background doping concentration in the surrounding portions of the substrate 12. As previously described, the doping concentration of the implantation 38 is chosen to counterbalance any effect on the CCD operation caused by the N impurity concentration of the implantation 36. The implant 38 is of the same conductivity-type as the substrate 12, but much higher in doping concentration. Both of the ion-implants 36 and 38 are concentrated near the surface of the substrate 12.

Figure 5b illustrates the contour of the electric field, E, (i.e., E-field profile) produced by the application of a fixed voltage to the clock electrode 24 above the doped regions 36 and 38.

As shown in Figure 5b, the E-field varies as a function of the integral of the doping concentration $p$, and along a dimension through the doped regions 36 and 38 and the underlying substrate 12. The solid line profile 50 illustrates the plot of the electric field in the absence of the implants 36 and 38, and the dashed line 52 is an integral of the relatively constant N and P type doping concentrations 46 and 48 in Figure 5a.

The substrate surface potential is illustrated in Figure 5c and is an integral of the electric field, E, i.e., $V = \int E(X)dX$, where "X" is the distance into the substrate. The purpose of Figure 5 is to show that the effect of the total integration represented by the dashed line 52 in Figure 5b on the surface potential V of the CCD memory cell is represented by the dashed line 56 in Figure 5c. Thus, whereas the surface potential V in Figure 5c for an undoped substrate 12 varies along the parabolic contour of the solid line 54 and into the substrate, the double doped substrate will now have a surface potential V which varies along the inverted parabolic contour 56 which is the integral of the E field profile 52 in the doped regions 36 and 38. The net result is that the integration represented by the curve portion 56 has a negligible effect on the surface potential V of the CCD memory cell, and this is a desirable feature provided by the present invention.

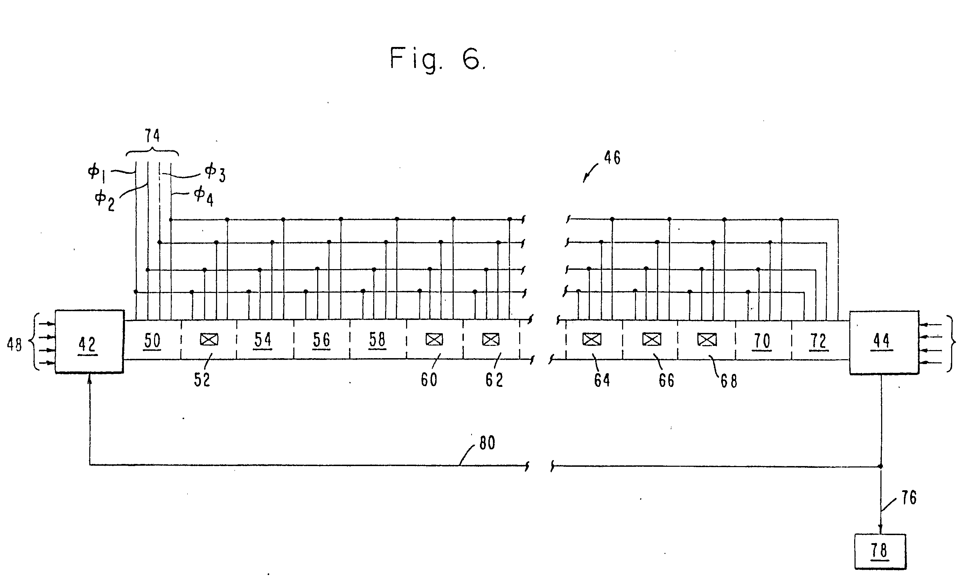

Referring now to Figure 6, a charge injection input circuit 42 of a type known and available in the art, such as in the publication of *Charge Transfer Device*, by C. Siquin and M. Tompett, Academic Press, Inc. New York, 1975, pp, 47—61, supplies charge which is fed into a first ROM cell 50 of the CCD ROM structure 46. The serially connected CCD cells 50—72 are adapted to receive the clocking signals $\phi_1$—$\phi_4$ of the four different phases indicated in Figure 7, and these clock signals are available from a clocking source 74. During fabrication of the serially connected CCD cells 50 through 72 on a single substrate, bits of binary information were stored as full potential wells of charge in predetermined ones of these CCD cells. These cells 52, 60—68 contain an "x" representing stored binary "1's" and these cells are similar to the CCD cell in Figure 2 and contain the double implanted or double diffused region 34 which stores the charge representative of a binary "1". The remaining cells 50, 54—58 and 70—72 that contain no fixed charge represent the binary "0's" for the charge processing circuitry of Figure 6.

The start up procedure for the CCD memory system 46 in Figure 6 is to apply the $\phi_1$—$\phi_4$ voltages from the clocking source 74 in the phase relationship shown in Figure 7, so that four electrodes in each CCD memory cell will receive one of the four $\phi_1$—$\phi_4$ clocking signals. During each cycle of the clocking voltages $\phi_1$—$\phi_4$, charge is transferred from one CCD cell 50—72 to the adjacent CCD cell to the right as shown in Figure 6. The output circuit 44 senses the charge in the last or output CCD cell 72 and converts it to a signal which is then applied to the input circuit 42 by feedback means 80. The feedback means 80 is preferably a bus line which serves to connect a refresh signal back into the first CCD memory cell 50. Therefore, the input circuit 42 is also a charge refreshing circuit in that it responds to both a feedback signal as well as a plurality of input signals 48.

The signal from the output circuit 44 is also supplied to an output bus 76 so that it can be further processed by an output utilization circuit 78 such as *Ibid.*, pp. 47—61. The eleven bit binary number 00111...1100010 is read out in the sequence indicated in the output circuit 44, which receives this sequential binary information from the last (eleventh) CCD cell 72. This binary number is dependent upon the fixed charge (or absence thereof) state of each of the eleven cells shown in Figure 6, and the number of bits in the binary number and the number of CCD cells will be the same. The duration of each binary bit, which may be digital information visible on a CRT or the like, i.e., block 44, corresponds to the duration of each clock cycle which is defined, for example, as time $t_1$ in Figure 7. Thus, the read-out of the above eleven bit binary number completed after eleven successive clock cycles i.e., at time $t_{11}$ and then the cycle starts over after the information is refreshed.

This CCD structure and clocking circuitry shown in Figure 6 is connected for use as a ROM. Once the stored data has begun to circulate (using the refresher feedback connection 80), the CCD functions in a known manner by transferring charges from one potential well to an adjacent potential well. In some instances, however, it may be desirable to disconnect the fixed charge ROM cells from the circuitry of Figure 6 and operate this circuitry as a standard serial CCD. This may be accomplished by applying an external data signal to the input circuit 42 rather than applying the signal from the refresher. During this time the original stored information will be temporarily lost.

When the original stored information needs to be retrieved from the ROM memory of Figure 6, either because the structure has been processing new charge or because the power has been turned off, it may be done by either one of two methods. The first method is to turn the CCD structure in Figure 6 off by shutting down the power applied thereto and allowing charge to thermally accumulate in the device. During this period, the potential wells that had been originally filled with charge will return to their equilibrium state i.e., fill with charge. This action is due to the excess electrons that are created by heat generation that are floating around in the system. The only requirement for turning on the system again is to allow enough time to pass after the ROM CCD is de-energized so that the implanted or diffused regions therein can fill up with the thermally induced charge. After such sufficient length of time has passed, charge will become concentrated only in the double implanted or double diffused regions and the CCD can be turned on again, containing the original stored information. The other way to retrieve the ROM information in the structure of Figure 6 is to apply a momentary input signal to all of the CCD cells. The charge in the structure of Figure 6 will instantly concentrate in the double doped regions in the ROM CCD cells therein. This second method is preferred in cases where the stored information is needed instantaneously, particularly since the thermal relaxation rate is relatively slow in the first method described above for information retrieval.

An example of an N channel silicon ROM cell, in accordance with the invention, may have (and is not limited to) the following parameters. The substrate would have a resistivity between 0.1 and $10^4$ ohm cm and a P type doping of $1 \times 10^{15}$ cm$^{-3}$. The first implant would have an N type arsenic implantation (the dose being $X1 \times 10^{12}$ cm$^{-2}$) leaving a doping concentration of $1 \times 10^{16}$ cm$^{-3}$ from the silicon-silicon oxide interface to 100 nm deep in the substrate. The second implant would have a P type boron implantation (the dose being $X1 \times 10^{12}$ cm$^{-2}$) leaving a doping concentration of $1 \times 10^{16}$ cm$^{-3}$ from 100 nm to 200 nm deep in the substrate. The lateral dimensions of these implants would correspond to the area of the storage gate 24. (The alignment of the implant with respect to the storage gate is not critical). The silicon wafer orientation should be (100) as used for standard NMOS technology.

Thus, there has been described a dynamic serial CCD ROM cell and associated structure and clocking structure which has an inherently larger packing density than known prior art solid state random access memories, such as the MNOS and FAMOS memories described above. In addition, the present ROM CCD memory exhibits certain improved operating characteristics and can function as a standard serial CCD without memory if desired.

## Claims

1. A non-volatile CCD read-only memory (ROM) comprising a semiconductor substrate (12) of a predetermined conductivity type and a plurality of charge transfer electrodes (16—32) selectively spaced above and insulated from, a major surface of the substrate and arranged to define a series of memory cells in the substrate, characterized in that each memory cell of said series is arranged beneath a corresponding one of said charge transfer electrodes and that selected ones of the memory cells include a double conductivity type region (34) consisting of a first region (36) adjacent said major surface and of a first conductivity type which is different from said predetermined conductivity type of the substrate (12), and a second region (38) adjacent said first region (36) and of a second conductivity type which is the same as the conductivity type of the substrate (12) but has a higher impurity concentration, whereby the resulting neutralizing effect enables the substrate (12) to receive a fixed charge as necessary for ROM operation without significantly changing the surface potential of the substrate and thus the clocked CCD operation.

2. A read-only memory according to claim 1, characterized in that said series of memory cells (50 to 72) includes input (50), output (72) and intermediate (52—70) cells, and there are provided input means (42) coupled to the input cell (50), output means (44) coupled to the output cell (72), a feedback connection (80) from the output means (44) to the input means (42), and a clocking signal source (74) coupled to said charge transfer electrodes (16 to 32) to transfer charges between successive ones of said memory cells.

3. A read-only memory according to claim 1 or 2, characterized in that the semiconductor substrate (12) has a resistivity of between 0.1 and $10^{14}$ ohm cm, the first region (36) has an impurity concentration of between $10^{12}$ and $10^{20}$ charge carriers per cubic centimeter, and the second region (38) has approximately the same impurity concentration as the first region (36) whereby the resulting neutralizing effect enables the substrate (12) to receive a fixed charge as necessary for ROM operation without significantly changing the surface potential of the substrate and thus the clocked CCD operation.

## Revendications

1. Une mémoire morte non volatile à dispositif à couplage de charge (DCC) comprenant un substrat semiconducteur (12) d'un type de conductivité prédéterminé et un ensemble d'électrodes de transfert de charge (16—32) espacées sélectivement au-dessus d'une surface principale du substrat et isolées de cette surface, en étant disposées de façon à définir une série de cellules de mémoire dans le substrat, caractérisée en ce que chaque cellule de mémoire de la série est placée au-dessous d'une électrode correspondante parmi les électrodes de transfert de charge, et en ce que des cellules sélectionnées parmi les cellules de mémoire comprennent une région (34) d'un double type de conductivité, consistant en une première région (36) adjacente à la surface principale, et d'un premier type de conductivité qui est différent du type de conductivité prédéterminé du substrat (12) et en une second région (38) adjacente à la première région (36) et d'un second type de conductivité qui est le même que le type de conductivité du substrat (12) mais qui a une concentration en impuretés supérieure, grâce à quoi l'effet de neutralisation résultant permet au substrat (12) de recevoir une charge fixe, comme il est nécessaire pour le fonctionnement en mémoire morte, sans changer notablement le potentiel de surface du substrat et donc le fonctionnement en DCC sous la dépendance d'une horloge.

2. Une mémoire morte selon la revendication 1, caractérisée en ce que la série de cellules de mémore (50 à 72) comprend des cellules d'entrée (50), de sortie (72) et intermédiaires (52—70), et il existe des moyens d'entrée (42) connectés à la cellule d'entrée (50), des moyens de sortie (44) connectés à la cellule de sortie (72), une connexion de réaction (80) des moyens des sortie (44) vers les moyens d'entrée (42), et une source de signal d'horloge (74) connectée aux électrodes de transfert de charge (16 à 32) pour transférer des charges entre des cellules de mémoire successives.

3. Une mémoire morte selon la revendication 1 ou 2, caractérisée en ce que le substrat semiconducteur (12) a une résistivité comprise entre 0,1 et $10^{14}$ ohm-cm, la première région (36) a une concentration en impuretés comprise entre $10^{12}$ et $10^{20}$ porteurs de charge par centimètre cube, et la seconde région (38) a approximativement la même concentration en impuretés que la première région (36), grâce à quoi l'effet de neutralisation résultant permet au substrat (12) de recevoir une charge fixe comme il est nécessaire pour le fonctionnement en mémoire morte, sans changer notablement le potentiel de surface du substrat et donc le fonctionnement en DCC sous la dépendance d'une horloge.

## Patentansprüche

1. Hicht-flüchtiger Nur-Lese-CCD-Speicher (ROM) mit einem Halbleitersubstrat (12) eines vorbestimmten Leitfähigkeitstyps und einer Mehrzahl von Ladungs-Übertragungselektroden (16—32), die einzeln im Abstand oberhalb einer Haupt-Oberfläche des Substrates und von dieser isoliert derart angeordnet sind, daß sie eine Reihe Speicherzellen im Substrat bilden, dadurch gekennzeichnet, daß jede Speicherzelle der Reihe neben einer zugeordneten Ladungs-Übertragungselektrode angeordnet ist, und daß einige ausgewählte Speicherzellen eine Zone (34) eines doppelten Leitfähigkeitstyps aufweisen, die aus einer ersten, an die Haupt-Oberfläche angrenzenden Zone (36) eines ersten, von dem vorbestimmten Leitfähigkeitstyp des Substrates (12) abweichenden Leitfähigkeitstyps sowie einer zweiten, an die erste Zone (36) angrenzenden Zone (38) eines zweiten, mit dem Leitfähigkeitstyp des Substrates (12) übereinstimmenden, jedoch eine höhere Störstellen-Konzentration aufweisenden Leitfähigkeitstyp besteht, wodurch der sich einstellende Neutraliserungseffekt ermöglicht, daß das Substrat (12) eine festgelegt, zum Arbeiten des ROM erforderliche Ladung empfängt, ohne daß das Oberflächenpotential des Substrates merklich und damit die Funktion des getakteten CCD verändert wird.

2. Nur-Lese-Speicher nach Anspruch 1, dadurch gekennzeichnet, daß die Reihe von Speicherzellen (50—72) Eingangs-(50), Ausgangs- (72) und Zwischenzellen (52—70) umfaßt, und daß Eingangsmittel (42) vorgesehen sind, die an die Eingangszelle (50) angeschlossen sind, daß Ausgangsmittel (44) vorgesehen sind, die an die Ausgangszelle (72) angeschlossen sind, daß eine Rückkopplungsverbindung (80) von den Ausgangsmitteln (44) zu den Eingangsmitteln (42) vorgesehen ist, sowie eine Taktsignalquelle (74) an die Ladungs-Übertragungselektroden (16—32) angeschlossen ist, um Ladungen zwischen aufeinanderfolgenden Speicherzellen zu übertragen.

3. Nur-Lese-Speicher nach Anspruch 1 oder 2, dadurch gekennzeichnet, daß das Halbleiter-Substrat (12) einen spezifischen Widerstand von 0,1 bis $10^{14}$ Ohm cm, die erste Zone (36) eine Störstellenkonzentration von $10^{12}$ bis $10^{20}$ Ladungsträgern/$cm^3$ und die zweite Zone (38) ungefähr dieselbe Störstellenkonzentration wie die erste Zone hat, wodurch der sich einstellende Neutralisierungseffekt ermöglicht, daß das Substrat (12) eine festgelegt, zum Arbeiten des ROM erforderliche Ladung empfängt, ohne daß das Oberflächenpotential des Substrates merklich und damit die Funktion des getakteten CCD verändert wird.

Fig. 1a.

Fig. b.

Fig. 2.

# Fig. 3a.

# Fig. 3b.

Fig. 3c.

Fig. 4a.

Fig. 4b.

3

# Fig. 5.

Fig. 6.

0 016 636

Fig. 7.